# EUROPEAN PATENT APPLICATION

(11) **EP 4 391 027 A1**
(43) Date of publication of application: **26.06.2024**
(21) Application number: 21956343.4
(22) Date of filing: 08.09.2021
(51) Int. Cl.: H01L 21/331, H01L 29/737

(54) **SEMICONDUCTOR STRUCTURE AND PREPARATION METHOD THEREFOR, AND RADIO FREQUENCY CIRCUIT**

(71) Applicant: Huawei Technologies Co., Ltd., Shenzhen, Guangdong 518129 (CN)
(72) Inventor: XU, Xiangming, Shenzhen, Guangdong 518129 (CN); JIAN, Zhongxiang, Shenzhen, Guangdong 518129 (CN)
(74) Representative: Epping - Hermann - Fischer
(86) International application number: PCT/CN2021/117293
(87) International publication number: WO 2023/035155

(57) **Abstract**

Embodiments of this application provide a semiconductor structure and a preparation method thereof, and a radio frequency circuit, and relate to the field of semiconductor technologies, to provide a SiGe HB device structure that has a relatively simple process and has a relatively large potential to implement high performance. The semiconductor structure includes: a substrate, including a collector region buried in the substrate; an intrinsic base region, disposed on a surface of the substrate, and in contact with the collector region on the surface of the substrate; an extrinsic base region, disposed on the surface of the substrate, located at a periphery of the intrinsic base region, and in contact with the intrinsic base region; an auxiliary layer having an opening, where the auxiliary layer is disposed on the extrinsic base region; an emitter region, disposed on the auxiliary layer, and in contact with the intrinsic base region through the opening; and an inner side wall, disposed between the extrinsic base region and the emitter region.

## Description

### TECHNICAL FIELD

This application relates to the field of semiconductor technologies, and in particular, to a semiconductor structure and a preparation method thereof, and a radio frequency circuit.

### BACKGROUND

A conventional silicon-based complementary metal oxide semiconductor (complementary metal oxide semiconductor, CMOS) has low process costs. CMOS devices can implement higher frequency response by using advanced process nodes, and is suitable for high-frequency applications. However, for same frequency response, the CMOS device has a lower breakdown voltage, while a silicon-germanium heterojunction bipolar transistor (SiGe heterojunction bipolar transistor, SiGe HBT) has a higher breakdown voltage, and is suitable for applications with higher output power. In addition, the SiGe HBT has higher transconductance than the CMOS device. Based on simulation prediction of a latest semiconductor simulation tool (Technology Computer Aided Design, TCAD), a current gain cut-off frequency limit of the SiGe HBT device is 1 THz, and a power gain cut-off frequency limit is 2 THz. In this case, the SiGe HBT device can meet high-frequency and high-speed application requirements for a long time. Moreover, electron and hole mobility of an III-V group material like GaAs (gallium arsenide) and InP (indium phosphate) is much higher than that of silicon, and the III-V group material has an excellent high-frequency characteristic. In addition, because of a high forbidden band width, the III-V group material has a higher breakdown voltage than that of the SiGe HBT, and is also suitable for high-frequency and high-power applications. However, the III-V material has disadvantages such as high costs, high environmental protection costs, poor heat conduction, and poor mechanical performance.

The CMOS and SiGe HBT are integrated on a same chip (CMOS+SiGe, SiGe BiCMOS). The SiGe HBT has advantages such as a high frequency, a high speed, high gain, and low noise, and is suitable for analog circuit design. The CMOS has an advantage of low power consumption, and is suitable for a digital logic circuit. The integration of the CMOS and SiGe HBT meets a requirement of digital-analog hybrid circuit design. Therefore, compared with the III-V materials, the SiGe BiCMOS has advantages such as low costs and high integration.

With gradual popularization of 5G communication, the SiGe BiCMOS plays an increasingly important role in applications of fields such as optoelectronic high-speed transmission, microwave high frequency, radar, images, and sensing. The SiGe HBT can be used to manufacture different radio frequency circuits such as an optoelectronic transimpedance amplifier, a driver, clock data recovery (clock data recovery, CDR), a microwave low noise amplifier, a frequency mixer, and a power amplifier.

How to use a relatively simple process to implement a SiGe HBT device with higher frequency response has become a continuous goal of SiGe process engineers.

### SUMMARY

Embodiments of this application provide a semiconductor structure and a preparation method thereof, and a radio frequency circuit, to resolve a problem of a complex preparation process and high costs of a high-performance HBT. To implement the foregoing objective, the following technical solutions are applied in this application.

According to a first aspect, an embodiment of this application provides a semiconductor structure, including: a substrate, including a collector region buried in the substrate; an intrinsic base region, disposed on a surface of the substrate, and in contact with the collector region on the surface of the substrate; an extrinsic base region, disposed on the surface of the substrate, located at a periphery of the intrinsic base region, and in contact with the intrinsic base region; an auxiliary layer having an opening, where the auxiliary layer is disposed on the extrinsic base region; an emitter region, disposed on the auxiliary layer, and in contact with the intrinsic base region through the opening; and an inner side wall, disposed between the extrinsic base region and the emitter region.

According to the semiconductor structure provided in this embodiment of this application, both the intrinsic base region and the extrinsic base region are disposed on the surface of the substrate, and the collector region is disposed inside the substrate. There is no raised epitaxial collector region on the surface of the substrate. Therefore, both the intrinsic base region and the extrinsic base region are directly formed on the surface of the known substrate, and whether the intrinsic base region is in contact with the extrinsic base region is directly controlled by preparation processes of the intrinsic base region and the extrinsic base region. Compared with the intrinsic base region disposed on the epitaxial collector region that is disposed on the surface of the substrate, the intrinsic base region is directly disposed on the surface of the substrate in this embodiment of this application. In this case, contact between the intrinsic base region and the extrinsic base region is not affected due to a parameter like a thickness of the raised collector region. This can improve a contact yield between the intrinsic base region and the extrinsic base region, and further improve a yield of the semiconductor structure. In addition, impact of the thickness of the collector region on contact effect between the intrinsic base region and the extrinsic base region does not need to be considered. Therefore, this can reduce a requirement for process accuracy of manufacturing the collector region, and reduce a process difficulty. In addition, the collector region is obtained through doping, and an epitaxy growth process (for preparing the collector region) is not needed. This saves processing costs.

In some embodiments, the substrate further includes a shallow trench isolation region, the shallow trench isolation region is disposed at a periphery of an active region under the intrinsic base region, and the collector region is located in the active region. Both the collector region and the shallow trench isolation region are located inside the substrate, and there is no raised epitaxial collector region. Contact between the intrinsic base region and the extrinsic base region is not affected due to a parameter like a thickness of the collector region. This can improve a contact yield between the intrinsic base region and the extrinsic base region, and further improve a yield of the semiconductor structure.

In some embodiments, the substrate further includes an auxiliary extrinsic base region, the auxiliary extrinsic base region is disposed in the shallow trench isolation region, and the extrinsic base region is in contact with the auxiliary extrinsic base region on the surface of the substrate. In addition, an auxiliary extrinsic base region is disposed in the substrate, and the auxiliary extrinsic base region functions as a seed layer for epitaxy growth of the extrinsic base region. After the extrinsic base region is grown, the auxiliary extrinsic base region is in contact with the extrinsic base region, to implement thickening of the extrinsic base region. This can implement an objective of reducing resistance of the extrinsic base region.

In some embodiments, the extrinsic base region includes a baselink region and an effective extrinsic base region, and the baselink region is in contact with both the intrinsic base region and the effective extrinsic base region. In this case, the effective extrinsic base region is in contact with the baselink region, and the baselink region is in contact with the intrinsic base region. This implements contact between the extrinsic base region and the intrinsic base region. A material of the baselink region is quasi-single-crystalline silicon, and an activation rate of a doping ion of the baselink region is greater than that of the effective extrinsic base region (a material is polycrystalline silicon). Therefore, the contact between the effective extrinsic base region and the intrinsic base region is implemented through the baselink region, so that contact resistance between the extrinsic base region and the intrinsic base region can be reduced.

In some embodiments, the baselink region is linked to the intrinsic base region and/or the effective extrinsic base region. Contact is implemented through linking, so that a requirement for process accuracy is reduced, and a process difficulty is reduced.

In some embodiments, the semiconductor structure further includes an outer side wall; and the outer side wall wraps a side surface of the emitter region, and is configured to protect the emitter region. The outer side wall can protect the emitter region in a preparation process of the semiconductor structure, preventing another epitaxy growth step from affecting the emitter region.

In some embodiments, the semiconductor structure further includes a cap layer, and the cap layer covers a surface that is of the emitter region and that is away from the substrate, and is configured to protect the emitter region. The outer side wall can protect the emitter region in a preparation process of the semiconductor structure, preventing another epitaxy growth step from affecting the emitter region.

In some embodiments, the inner side wall includes an inner wall body, the inner wall body is disposed on a surface that is of the extrinsic base region and that faces the emitter region, and the inner wall body is L-shaped. The L-shaped inner wall body has a wide coverage area, and can improve isolation effect between the extrinsic base region and the emitter region.

In some embodiments, the semiconductor structure further includes an emitter electrode, a base electrode, and a collector electrode that are disposed on the substrate. The emitter electrode is in contact with the emitter region, the base electrode is in contact with the extrinsic base region, and the collector electrode is in contact with the collector region.

In some embodiments, the substrate further includes a sinker region and a buried collector region, the sinker region and the shallow trench isolation region are located on the buried collector region, the sinker region is located on a side that is of the shallow trench isolation region and that is away from the collector region, and both the sinker region and the collector region are in contact with the buried collector region. The collector electrode is in contact with the collector region through a connection hole that is in contact with the sinker region. The emitter electrode is in contact with the emitter region through a connection hole that passes through the cap layer and is in contact with the emitter region. The base electrode is in contact with the extrinsic base region through a connection hole that is in contact with the extrinsic base region.

In some embodiments, the semiconductor structure further includes a complementary metal-oxide-semiconductor field-effect transistor, and the complementary metal-oxide-semiconductor field-effect transistor is disposed on the substrate. In this case, the semiconductor structure is a CMOS+SiGe HBT device, and the CMOS and the SiGe HBT may be integrated on a same chip, so that advantages of both the CMOS and the SiGe HBT may be obtained.

According to a second aspect, an embodiment of this application provides a radio frequency circuit, including a transistor circuit that includes the semiconductor structure in the first aspect.

According to a third aspect, an embodiment of this application provides a preparation method for a semiconductor structure. The method includes: forming a base, where the base includes an active region and a shallow trench isolation region; forming, on a surface of the base, a first sacrificial film, a second sacrificial film, and an auxiliary film that are sequentially stacked, forming a second opening in the second sacrificial film, and forming a third opening in the auxiliary film, where the second opening is in communication with the third opening to function as an emitter region window; forming a first inner side wall, where the first inner side wall is disposed around a surface that is of the second sacrificial film and that faces the emitter region window; forming a collector region, where the collector region is located in an active region directly below the emitter region window; forming a first opening in the first sacrificial film, where the first opening is in communication with the second opening; forming an intrinsic base region in the first opening; forming, at the emitter region window, an emitter region film that is in contact with the intrinsic base region, and patterning the emitter region film and the auxiliary film, to form an emitter region and an auxiliary layer; and removing the first sacrificial film and the second sacrificial film to form an extrinsic base region at corresponding positions, where the extrinsic base region is in contact with the intrinsic base region.

According to the preparation method for the semiconductor structure provided in this embodiment of this application, the first sacrificial film, the second sacrificial film, and the auxiliary film function as self-aligned structures, and may be used to implement self-alignment of a collector junction and self-alignment of an emitter junction. In this case, the collector junction and the emitter junction that are obtained through preparation are axisymmetric structures, and no deviations occur in photolithography and etching processes, preventing asymmetry in both the collector junction and the emitter junction. The emitter junction is asymmetric. As a result, parasitic collector junction capacitance and base region resistance on two sides of the emitter junction are different, a current cannot be evenly distributed on the two sides, and total resistance and capacitance cannot be minimized. The two sides are symmetric, so that the base region resistance and the collector junction capacitance can be minimized, and a maximum oscillation frequency of the device is increased. The collector junction is asymmetric. As a result, parasitic collector resistance on two sides of the collector junction is different, and an objective of reducing the collector resistance cannot be implemented either. In addition, in this embodiment of this application, preparation of each film layer may be implemented by using a conventional technology. The collector region is also formed by defining a position by using the self-aligned structure and then performing ion implantation on the substrate. Both the intrinsic base region and the extrinsic base region are disposed on the surface of the substrate, and there is no raised epitaxial collector region. Therefore, contact between the intrinsic base region and the extrinsic base region is not affected due to a parameter like a thickness of the collector region. This reduces a requirement for process accuracy, and reduces a process difficulty. An epitaxy growth process is not needed. This saves processing costs.

In some embodiments, the forming a base further includes: forming an auxiliary extrinsic base region in the shallow trench isolation region, where the extrinsic base region is in contact with the auxiliary extrinsic base region on the surface of the base. In addition, an auxiliary extrinsic base region is disposed in the substrate, and the auxiliary extrinsic base region functions as a seed layer for epitaxy growth of the extrinsic base region. After the extrinsic base region is grown, the auxiliary extrinsic base region is in contact with the extrinsic base region, to implement thickening of the extrinsic base region. This can implement an objective of reducing resistance of the extrinsic base region.

In some embodiments, the removing the first sacrificial film and the second sacrificial film to form an extrinsic base region at corresponding positions includes: removing the second sacrificial film to form a baselink region under the auxiliary layer, where the baselink region is in contact with the intrinsic base region; and removing the first sacrificial film to form an effective extrinsic base region at a corresponding position, where the effective extrinsic base region is in contact with the baselink region. In this case, the effective extrinsic base region is in contact with the baselink region, and the baselink region is in contact with the intrinsic base region. This implements contact between the extrinsic base region and the intrinsic base region. A material of the baselink region is quasi-single-crystalline silicon, and an activation rate of a doping ion of the baselink region is greater than that of the effective extrinsic base region (a material is polycrystalline silicon). Therefore, the contact between the effective extrinsic base region and the intrinsic base region is implemented through the baselink region, so that contact resistance between the extrinsic base region and the intrinsic base region can be reduced.

In some embodiments, a contour of the second opening is within a contour of the first opening. In this case, the subsequently formed baselink region is linked to the intrinsic base region and/or the effective extrinsic base region. Contact is implemented through linking, so that a requirement for process accuracy is reduced, and a process difficulty is reduced.

In some embodiments, before the forming, at the emitter region window, an emitter region that is in contact with the intrinsic base region, the preparation method further includes: removing the first inner side wall, to form a second inner side wall. After the first inner side wall is formed, when ion implantation is performed to form the collector region, ion implantation is performed on the first inner side wall, affecting isolation effect between the extrinsic base region and the emitter region that are subsequently formed. Therefore, after the first inner side wall is removed and the second inner side wall is formed again, the foregoing problem can be resolved, and the isolation effect between the extrinsic base region and the emitter region can be improved. In addition, in a process of forming the first opening, a part that is of the first inner wall body and that is in contact with the first sacrificial film is removed synchronously, that is, a cross section of the first inner wall body is strip-shaped. As a result, the first inner wall body cannot implement isolation in the region. A third inner wall body included in the second inner wall body that is formed again is L-shaped and has a wide coverage area, so that isolation effect between the extrinsic base region and the emitter region can be improved.

In some embodiments, after the forming a second inner side wall, the preparation method further includes: cleaning a surface of the intrinsic base region, to remove an intrinsic oxide layer. After the intrinsic base region is formed, the step of removing the first inner side wall to form the second inner side wall is performed. As a result, an exposed surface of the intrinsic base region is prone to oxidation to produce SiO2, which affects electrical contact effect between the subsequently formed emitter region and the subsequently intrinsic base region, leading to higher resistance in the emitter region. The surface of the intrinsic base region is cleaned, so that SiO2 on the surface of the intrinsic base region can be removed. This improves the electrical contact effect between the subsequently formed emitter region and the subsequently intrinsic base region, facilitates epitaxy growth of a single crystal material in the emitter region, and effectively reduces resistance of the emitter region.

In some embodiments, the preparation method further includes: forming a complementary metal-oxide-semiconductor field-effect transistor on the base. In this way, the semiconductor structure obtained through preparation is a CMOS+SiGe HBT device, and the CMOS and the SiGe HBT may be integrated on a same chip, so that advantages of both the CMOS and the SiGe HBT may be obtained.

### BRIEF DESCRIPTION OF DRAWINGS

FIG. 1 is a diagram of a preparation process of a semiconductor structure according to an embodiment of this application;
FIG. 2 is a flowchart of preparing a semiconductor structure according to an embodiment of this application;
FIG. 3A(1) to FIG. 3M are diagrams of a preparation process of another semiconductor structure according to an embodiment of this application;
FIG. 4A is a schematic diagram of a structure of a semiconductor structure according to an embodiment of this application;
FIG. 4B is a schematic diagram of a structure of another semiconductor structure according to an embodiment of this application;
FIG. 5A is a schematic diagram of a structure of still another semiconductor structure according to an embodiment of this application;
FIG. 5B is a schematic diagram of a structure of still another semiconductor structure according to an embodiment of this application; and
FIG. 6 is a schematic diagram of a structure of still another semiconductor structure according to an embodiment of this application.

### DESCRIPTION OF EMBODIMENTS

The following describes the technical solutions in embodiments of this application with reference to the accompanying drawings in embodiments of this application. It is clearly that the described embodiments are only some rather than all of embodiments of this application.

The terms "first" and "second" in embodiments of this application are merely intended for ease of description, and shall not be understood as an indication or implication of relative importance or implicit indication of a quantity of indicated technical features. Therefore, a feature limited by "first", "second" and the like may explicitly indicate or implicitly include one or more such features. In description of this application, unless otherwise stated, "a plurality of" means two or more than two.

In embodiments of this application, "up", "down", "left", and "right" are not limited to definitions relative to directions in which components are schematically placed in the accompanying drawings. It should be understood that these directional terms may be relative concepts used for relative description and clarification, and may change correspondingly based on a change of a direction in which a component in the accompanying drawings is placed.

In embodiments of this application, unless otherwise specified in the context, in the entire specification and claims, the term "include" is interpreted as "open and inclusive", that is, "include, but not limited to". In the description of this specification, the terms such as "one embodiment", "some embodiments", "example embodiment", "example", or "some examples" are intended to indicate that specific features, structures, materials, or features related to the embodiments or examples are included in at least one embodiment or example of the present disclosure. The schematic representations of the foregoing terms do not necessarily refer to a same embodiment or example. Moreover, the particular feature, structure, material, or characteristic may be included in any one or more embodiments or examples in any appropriate manner.

When some embodiments are described, expressions of "coupled" and "connected" and their extensions may be used. For example, when some embodiments are described, the term "connected" may be used to indicate that two or more components are in direct physical contact or electrical contact with each other. For another example, when some embodiments are described, the term "coupled" may be used to indicate that two or more components are in direct physical contact or electrical contact. However, the term "coupled" may also mean that two or more components are not in direct contact with each other, but still cooperate or interact with each other. The embodiments disclosed herein are not necessarily limited to the content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In embodiments of this application, example implementations are described with reference to sectional views and/or plane diagrams and/or equivalent circuit diagrams as idealized example accompanying drawings. In the accompanying drawings, for clarity, thicknesses of both layers and regions are enlarged. Therefore, it can be envisioned that a change occurs in shapes of the drawings due to, for example, a manufacturing technique and/or tolerances. Therefore, example implementations shall not be interpreted as being limited to shapes of regions shown in this specification, but include a shape deviation due to, for example, manufacturing. For example, an etching region shown as a rectangle usually has a bending characteristic. Therefore, the regions shown in the accompanying drawings are essentially examples, and the shapes are not intended to show actual shapes of the regions of a device, and are not intended to limit the scope of the example implementations.

A silicon-germanium heterojunction bipolar transistor (SiGe heterojunction bipolar transistor, SiGe HBT) has better thermal conductivity and a substrate has good mechanical performance. Therefore, a heat dissipation problem of a semiconductor structure can be resolved satisfactorily. In addition, the SiGe HBT has better linearity, higher integration, and good compatibility with a complementary metal oxide semiconductor (complementary metal oxide semiconductor, CMOS) technology. Therefore, the SiGe HBT is widely used in fields such as optoelectronics, radio frequency, and microwave, and especially to high-frequency devices in the foregoing fields. For example, for some high-frequency analog devices that use an optoelectronic high-speed transmission technology and a microwave high-frequency technology, a high-frequency analog device obtained by using a SiGe BiCMOS structure has advantages of the SiGe HBT structure, such as a high speed, a high gain, low noise, and low power consumption of a CMOS device. However, how to prepare a high-performance SiGe HBT structure through a simple process becomes a technical problem that a person skilled in the art continuously studies.

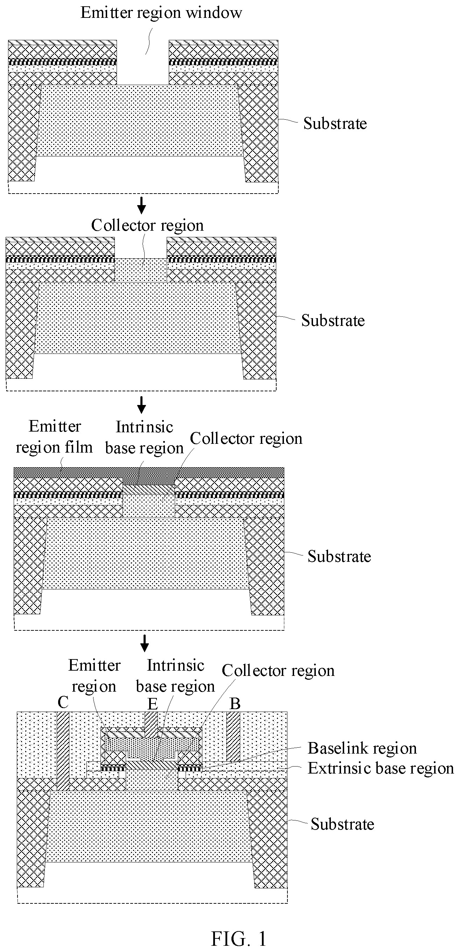

In some embodiments, as shown in FIG. 1, a preparation method for a semiconductor structure is provided. An emitter region window is first defined; then a selective epitaxy growth (selective epitaxy growth, SEG) process is used on a substrate 10, to form a collector region in the emitter region window; then, a selective epitaxy growth process is used on the collector region, to form an intrinsic base region and an emitter region film in the emitter region window; and then structures such as the emitter region and an extrinsic base region are prepared subsequently. As shown in FIG. 1, in the semiconductor structure obtained through preparation by using the foregoing preparation method, the collector region, the intrinsic base region, and the emitter region are all disposed above the substrate.

The semiconductor structure is obtained through preparation by using the foregoing method. The semiconductor structure obtained through preparation by using a full self-alignment process in which the collector region, the intrinsic base region, and the emitter region grow in the same emitter region window has an advantage of a self-aligned structure. However, the selective epitaxy growth process is further used in the collector region, causing a preparation cost increase. Moreover, in the process of forming the collector region through epitaxy growth, height control of the collector region determines relative positions of the intrinsic base region and the extrinsic base region. As shown in FIG. 1, the intrinsic base region is in contact with the extrinsic base region through a baselink region. If a height of the collector region is not appropriate, contact between the intrinsic base region disposed on the collector region and the baselink region is extremely scarce or nonexistent, affecting connection resistance between the intrinsic base region and the extrinsic base region. In other words, the height of the collector region determines relative positions of the intrinsic base region and the baselink region, and directly affects the connection resistance between the intrinsic base region and the extrinsic base region, affecting device performance. Therefore, in a process of preparing the semiconductor structure, a relatively high requirement is imposed on process accuracy. If the process accuracy does not meet the requirement, performance of the prepared semiconductor structure is greatly affected.

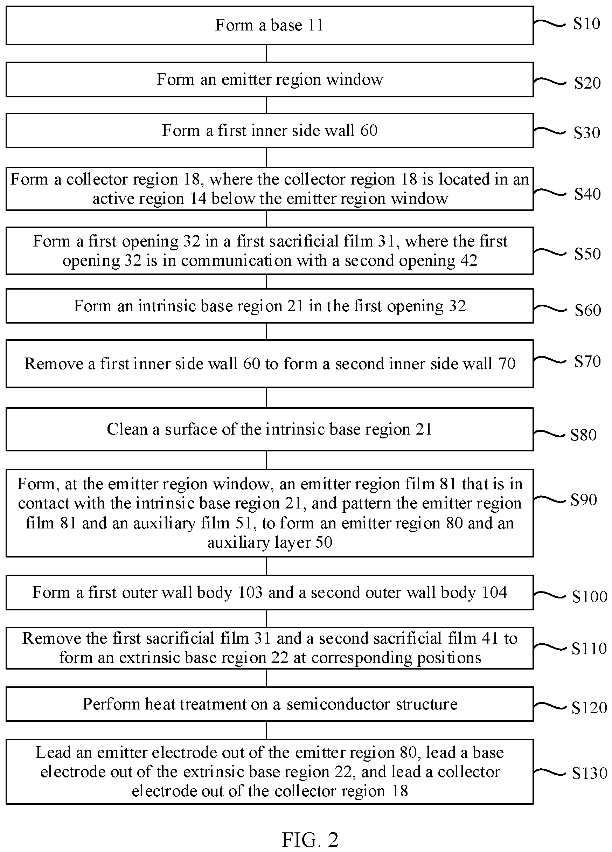

Based on this, an embodiment of this application further provides a preparation method for a semiconductor structure. As shown in FIG. 2, the method includes the following steps.

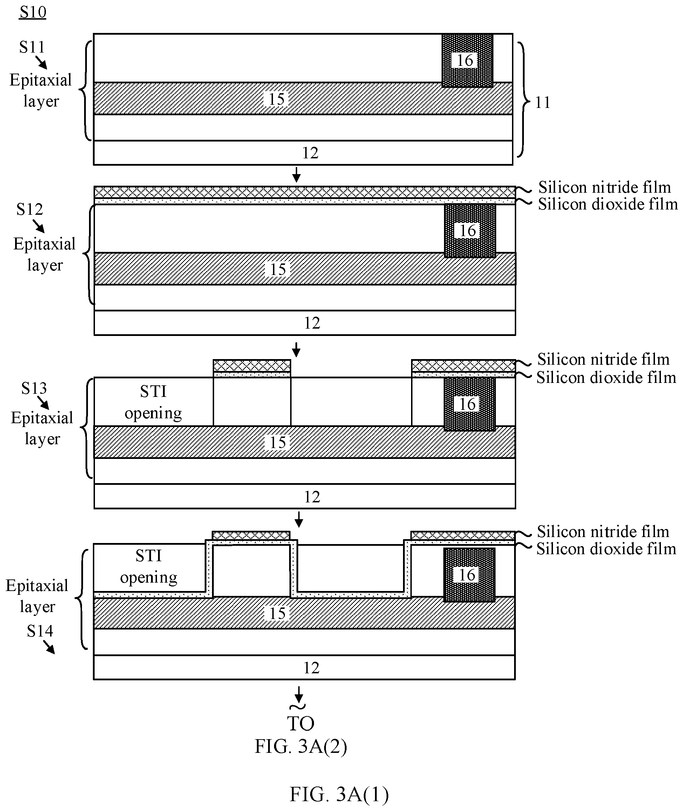

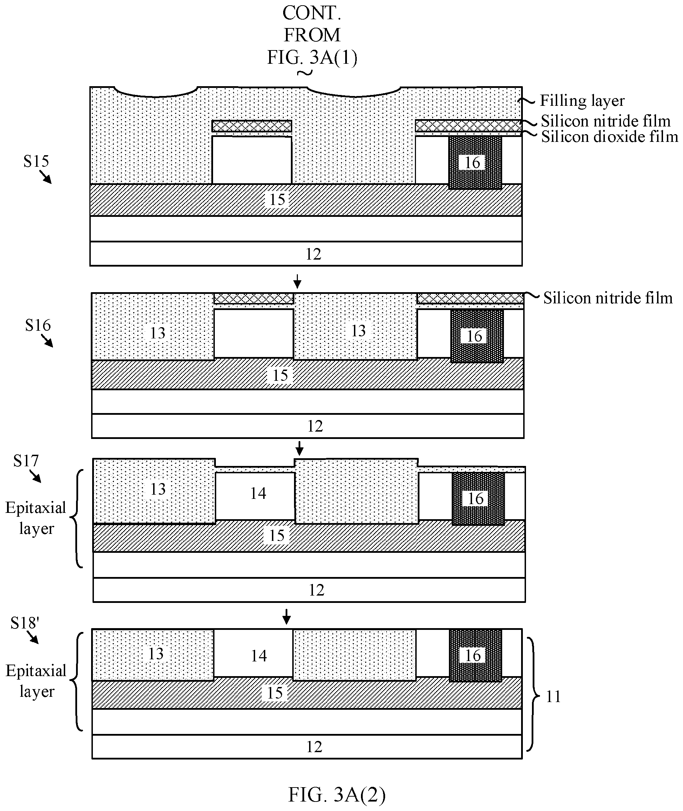

S10: Form a base 11, as shown in FIG. 3A(1).

In some embodiments, as shown in FIG. 3A(1) and FIG. 3A(2), a method for forming the base 11 includes the following steps.

S11: Form an epitaxial layer on a silicon substrate 12, and perform ion implantation on the epitaxial layer, to form a buried collector region 15 and a sinker region (sinker) 16.

Ion implantation of the buried collector region 15 is completed before an STI opening is formed. Ions may be implanted before formation of the epitaxial layer, and then diffused into the epitaxial layer at a high temperature. Alternatively, ion implantation may be performed after the epitaxial layer is formed, to form the buried collector region 15. An order of forming the buried collector region 15 is merely an example. This is not limited.

Certainly, before the buried collector region 15 and the sinker region 16 are formed, a screen oxide (screen oxide) layer may be formed. In this way, the screen oxide layer can protect a lattice of the silicon substrate 12 from being damaged. After the buried collector region 15 and the sinker region 16 are formed, the screen oxide layer may be removed, and then subsequent steps are performed.

Certainly, no epitaxial layer may alternatively be formed on the silicon substrate 12. In this case, the buried collector region 15 and the sinker region 16 are located in the silicon substrate 12. This embodiment of this application is described by using an example in which the epitaxial layer is formed on the silicon substrate 12.

S12: Form a silicon dioxide (SiO2) film and a silicon nitride (Si3N4) film on the epitaxial layer.

S13: Form the shallow trench isolation (shallow trench isolation, STI) opening in the epitaxial layer.

For example, the STI opening is formed through photolithography and dry etching. Certainly, another process may alternatively be used. S14: Oxidize and repair a surface of the STI opening, to form a silicon dioxide interface.

S15: Fill the STI opening with a dielectric material, to form a filling layer.

The dielectric material is, for example, SiO2 or another field-effect oxide. The dielectric material may or may not cover the Si3N4 film, but the STI opening needs to be fully filled with the dielectric material.

S16: Process the filling layer to form a shallow trench isolation (shallow trench isolation, STI) region 13.

For example, the filling layer may be ground through a chemical mechanical polishing (chemical mechanical polishing, CMP) process, to stay at a Si3N4 film layer.

S17: Remove the Si3N4 film to form the base 11.

For example, the Si3N4 film may be removed through wet etching. In this case, a region filled with the SiO2 in the epitaxial layer is the STI region 13, and a remaining region is an active region 14 of the base 11.

In some embodiments, after step S17 is performed, preparation of the base 11 is basically completed, and then S18' may be performed, to remove a redundant SiO2 film and expose a silicon surface of the base 11.

Based on this, the obtained base 11 is shown in FIG. 3A(1) and FIG. 3A(2). The base 11 includes the silicon substrate 12 and the epitaxial layer disposed on the silicon substrate 12. The epitaxial layer is divided into the STI region 13, the active region 14, the buried collector region 15, and the sinker region 16. Both the sinker region 16 and the STI region 13 are located on the buried collector region 15. The sinker region 16 is in contact with the buried collector region 15.

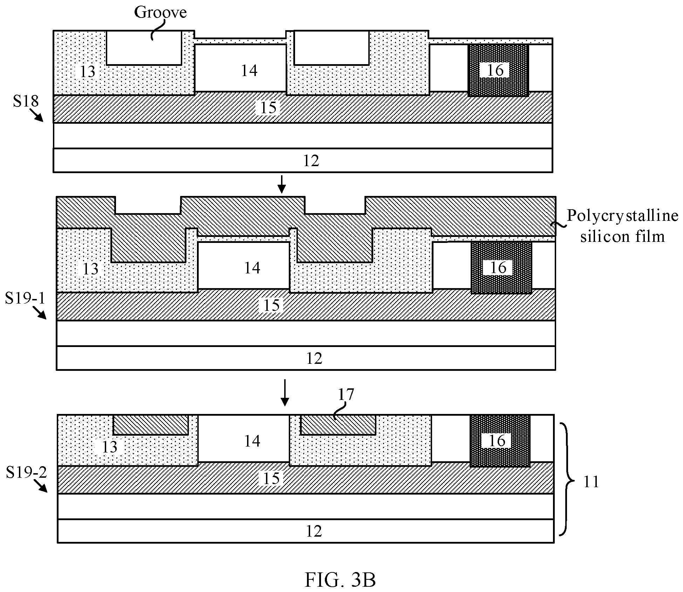

In some other embodiments, as shown in FIG. 3B, after step S17 is performed, the step of forming a base 11 further includes: forming an auxiliary extrinsic base region 21 in the STI region 13.

For example, the forming the auxiliary extrinsic base region 21 in the STI region 13 includes the following steps. S18: Form a groove below the to-be-formed extrinsic base region in the STI region 13.

For example, the groove is formed in the STI region 13 through photolithography and dry etching.

S19-1: Form a polycrystalline silicon film on the surface of the base 11.

For example, the polycrystalline silicon film may be formed through an epitaxy growth process, or the polycrystalline silicon film may be formed through a chemical vapor deposition (chemical vapor deposition, CVD) process.

A material of the polycrystalline silicon film may be polycrystalline silicon, polycrystalline silicon silicide, or the like. In some embodiments, after the polycrystalline silicon film is formed, doping may be performed on the polycrystalline silicon film. In-situ doping may be performed on the polycrystalline silicon film. Alternatively, the polycrystalline silicon film may be formed, and then ion implantation is performed to implement doping.

S19-2: Pattern the polycrystalline silicon film, and remove the redundant SiO2 film on the surface of the base 11, to form the auxiliary extrinsic base region 17 located in the groove in the STI region 13.

For example, the SiO2 film may function as a barrier layer, and the polycrystalline silicon film is ground through the CMP process, to remove the polycrystalline silicon film located outside the groove. The redundant SiO2 film may be removed through wet etching or dry etching.

In some embodiments, a surface of the auxiliary extrinsic base region 17 is higher than a surface of the STI region 13. In some other embodiments, as shown in FIG. 3B, a surface of the auxiliary extrinsic base region 17 is flush with a surface of the STI region 13.

For example, the base 11 may be ground through the CMP process, so that the surface of the auxiliary extrinsic base region 17 is flush with the surface of the STI region 13. In visual effect, this is equivalent to burying the auxiliary extrinsic base region 17 in the STI region 13. Certainly, a height difference within a process error range falls within the protection scope of this embodiment of this application.

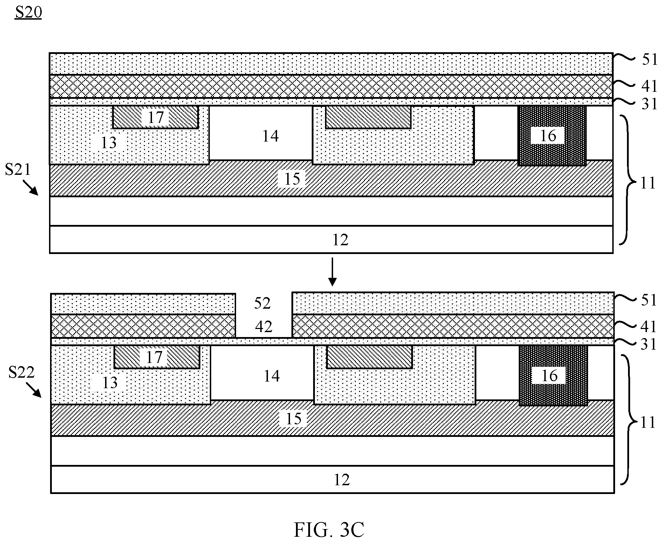

S20: Form an emitter region window, as shown in FIG. 3C.

In some embodiments, a manner of forming the emitter region window includes the following steps.

S21: Form a first sacrificial film 31, a second sacrificial film 41, and an auxiliary film 51 that are sequentially stacked on the surface of the base 11, as shown in FIG. 3C.

Materials of the first sacrificial film 31 and the auxiliary film 51 are the same, and materials of the first sacrificial film 31 and the second sacrificial film 41 are different.

For example, materials of the first sacrificial film 31, the second sacrificial film 41, and the auxiliary film 51 may all be, for example, silicide.

For example, materials of the first sacrificial film 31 and the auxiliary film 51 are silicon-containing oxides. For example, materials of the first sacrificial film 31 and the auxiliary film 51 are SiO2, silicon oxynitride, or oxygen-rich silicon dioxides.

For example, a material of the second sacrificial film 41 is silicon-containing nitride. For example, a material of the second sacrificial film 41 is Si3N4.

A manner of forming the first sacrificial film 31, the second sacrificial film 41, and the auxiliary film 51 may be, for example, forming the first sacrificial film 31, the second sacrificial film 41, and the auxiliary film 51 through the chemical vapor deposition (chemical vapor deposition, CVD) process.

S22: Form a third opening 52 in the auxiliary film 51, and form a second opening 42 in the second sacrificial film 41, as shown in FIG. 3C.

For example, the third opening 52 may be formed in the auxiliary film 51 through photolithography and etching processes. The second opening 42 may be formed in the second sacrificial film 41 through the photolithography and etching processes.

The third opening 52 and the second opening 42 may be formed in two processes, or may be formed in a same process. This is not limited in this embodiment of this application.

As shown in FIG. 3C, the formed second opening 42 is in communication with the third opening 52 to function as the emitter region window. The first sacrificial film 31 is still reserved at a bottom of the emitter region window, and is not directly connected to the base 11.

In some embodiments, as shown in FIG. 3C, the second opening 42 and the third opening 52 are aligned with each other and have a same size. Alternatively, it is understood that an orthographic projection of the second opening 42 on the base 11 coincides with an orthographic projection of the third opening 52 on the base 11.

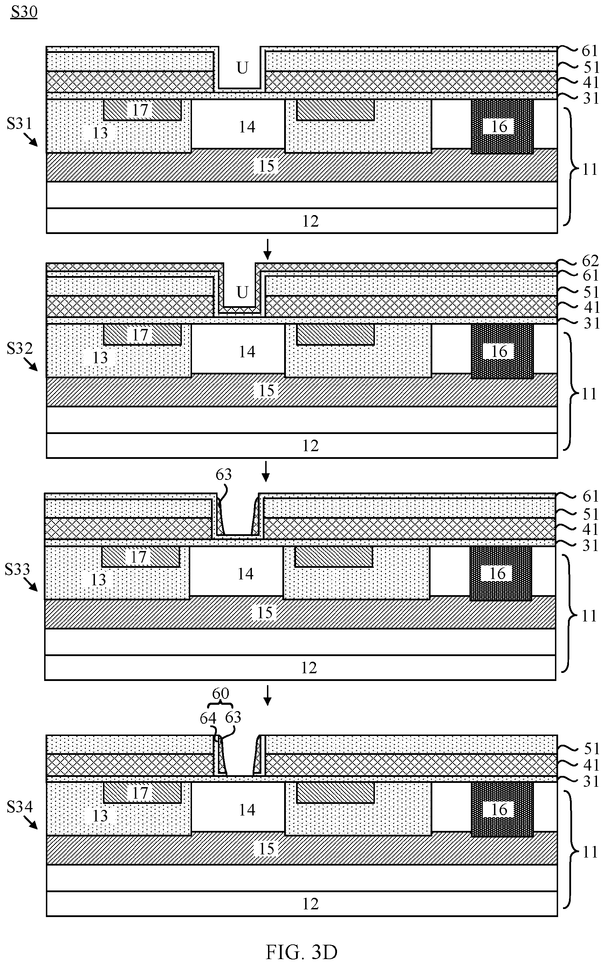

S30: Form a first inner side wall 60, as shown in FIG. 3D.

The formed first inner side wall 60 is disposed around a surface that is of the second sacrificial film 41 and that faces the second opening 42 (the emitter region window).

In some embodiments, as shown in FIG. 3D, the formed first inner side wall 60 further extends to a surface that is of the auxiliary film 51 and that faces the third opening 52.

In some embodiments, a manner of forming the first inner side wall 60 includes the following steps.

S31: Form a first dielectric film 61 on a surface of the auxiliary film 51, where the first dielectric film 61 forms a groove U at the emitter region window, as shown in FIG. 3D.

A material of the first dielectric film 61 may be a dielectric material, and a material of the first dielectric film 61 is, for example, silicide. For example, the material of the first dielectric film 61 is SiO2, Si3N4, silicon oxynitride, or oxygen-rich silicon dioxide.

In some embodiments, the material of the first dielectric film 61 is different from the material of the second sacrificial film 41. For example, the material of the first dielectric film 61 is SiO2, and the material of the second sacrificial film 41 is Si3N4.

A manner of forming the first dielectric film 61 may be, for example, forming the first dielectric film 61 through the CVD process.

S32: Form a second dielectric film 62 on the first dielectric film 61, as shown in FIG. 3D.

A manner of forming the second dielectric film 62 may be, for example, forming the second dielectric film 62 through the CVD process.

A material of the second dielectric film 62 may be a dielectric material, and a material of the second dielectric film 62 is, for example, silicide. For example, the material of the second dielectric film 62 is SiO2, Si3N4, silicon oxynitride, or oxygen-rich silicon dioxide.

In some embodiments, the material of the first dielectric film 61 is different from the material of the second dielectric film 62. For example, the material of the first dielectric film 61 is SiO2, and the material of the second dielectric film 62 is Si3N4.

In other words, in some embodiments, the material of the second sacrificial film 41 is Si3N4, the material of the first dielectric film 61 is SiO2, and the material of the second dielectric film 62 is Si3N4.

In this way, the first dielectric film 61 blocks a side surface of the second sacrificial film 41, to prevent damage to the second sacrificial film 41 when the second dielectric film 62 is patterned.

S33: Pattern the second dielectric film 62, to form a second inner wall body 63, where the second inner wall body 63 covers a side surface of the groove U, as shown in FIG. 3D.

For example, the second dielectric film 62 may be patterned through a dry etching process, to form the second inner wall body 63.

S34: Remove a part that is of the first dielectric film 61 and that is not covered by the second inner wall body 63, to form a first inner wall body 64, as shown in FIG. 3D.

For example, the first dielectric film 61 may be patterned through a dry etching process, to form the first inner wall body 64.

Based on this, as shown in FIG. 3D, the first inner side wall 60 of the semiconductor structure includes the first inner wall body 64 and the second inner wall body 63. The first inner side wall 60 exposes the first sacrificial film 31. Certainly, step S34 may not be performed, and when a collector region 18 is subsequently formed, the first dielectric film 61 and the first sacrificial film 31 jointly function as the screen oxide layer.

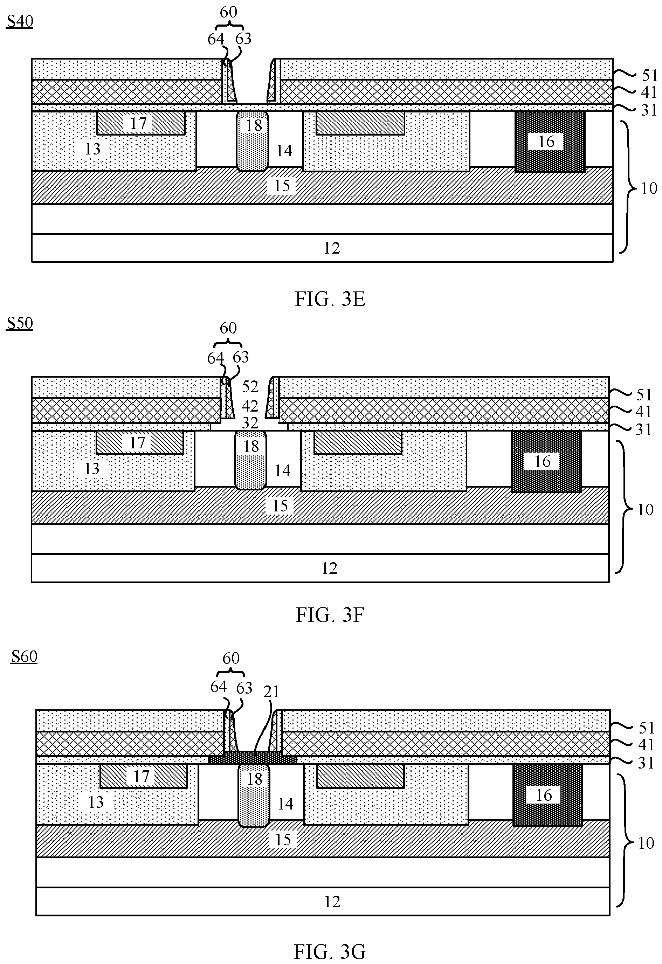

S40: Form the collector region 18, where the collector region 18 is located in the active region 14 below the emitter region window, as shown in FIG. 3E.

As shown in FIG. 3E, after step S40 is performed, preparation of the substrate 10 of the semiconductor structure is completed. The collector region 18 is located in a region enclosed by the STI region 13, and the collector region 18 is in contact with the buried collector region 15.

The emitter region window functions as a self-aligned window, the first sacrificial film 31 functions as the screen oxide (screen oxide) layer, and an ion implantation process is used in selective implantation (selected implanted), to form the collector (collector) region 18. In this way, the screen oxide layer can protect a lattice of the base 11 from being damaged, and the prepared collector region 18 is well directly aligned with the emitter region window. After the emitter region is subsequently formed in the emitter region window, alignment effect between the emitter region and the collector region 18 is good.

S50: Form a first opening 32 in the first sacrificial film 31, where the first opening 32 is in communication with the second opening 42, as shown in FIG. 3F.

For example, the first sacrificial film 31 located under the second opening 42 is removed through wet etching, to form the first opening 32. Because wet etching is isotropic, if materials of the first inner wall body 64 and the first sacrificial film 31 are the same (for example, are both SiO2), in a process of forming the first opening 32, the first inner wall body 64 located under the second inner wall body 63 is also removed.

It should be understood that an etching amount of the first sacrificial film 31 may be controlled by controlling an etching time period. In other words, a size of the first opening 32 may be controlled by controlling the etching time period.

In some embodiments, to improve contact effect between an extrinsic base region and an intrinsic base region that are subsequently prepared, as shown in FIG. 3F, a contour of the second opening 42 is within a contour of the first opening 32. Alternatively, it is understood that an orthographic projection of the second opening 42 on the substrate 10 is within an orthographic projection of the first opening 32 on the substrate 10. In other words, the first opening 32 is larger than the second opening 42, and there is a hole under the second sacrificial film 41.

S60: Form the intrinsic base region 21 in the first opening 32, as shown in FIG. 3G.

For example, the intrinsic base region 21 may be selectively epitaxially grown on the surface of the substrate 10 through a selective epitaxy growth process. A material of the intrinsic base region 21 may include, for example, SiGe (silicon germanium) and SiGe:C (silicon-germanium-carbon) alloy.

As shown in FIG. 3G, if there is the hole under the second sacrificial film 41, the hole is filled with the intrinsic base region 21.

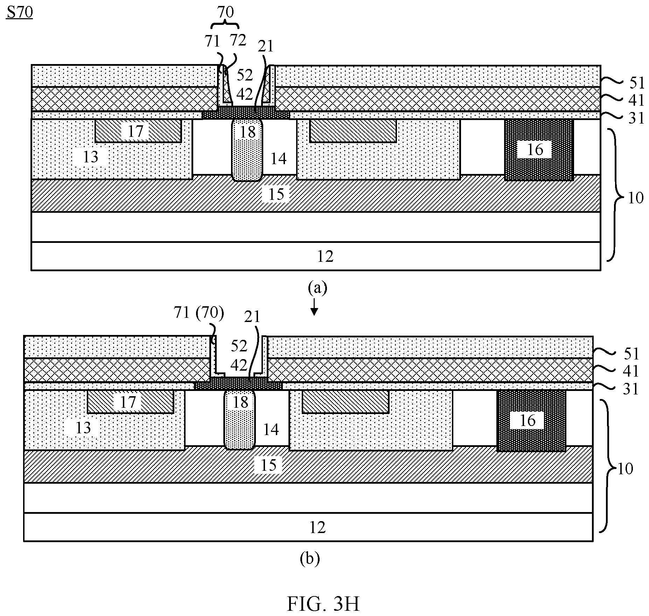

S70: Remove the first inner side wall 60, to form a second inner side wall 70, as shown in FIG. 3H.

A method for forming the second inner side wall 70 may be the same as the foregoing method for forming the first inner side wall 60. For details, refer to the foregoing description of step S30. Details are not described herein again. In some embodiments, as shown in FIG. 3H(a), the formed second inner side wall 70 includes a third inner wall body 71 and a fourth inner wall body 72. The third inner wall body 71 is disposed around both a surface that is of the second sacrificial film 41 and that faces the second opening 42 and a surface that is of the auxiliary film 51 and that faces the third opening 52. The third inner wall body 71 is L-shaped. The fourth inner wall body 72 is disposed on the third inner wall body 71, and is not directly in contact with the intrinsic base region 21.

For example, materials of the third inner wall body 71 and the first inner wall body 64 are the same. For example, a material of the third inner wall body 71 is SiO2. Materials of the fourth inner wall body 72 and the second inner wall body 63 are the same. For example, a material of the fourth inner wall body 72 is Si3N4.

In some other embodiments, as shown in FIG. 3H(b), the formed second inner side wall 70 includes the third inner wall body 71. In other words, after the third inner wall body 71 and the fourth inner wall body 72 are obtained through preparation through a process that is the same as that in step S30, a step of removing the fourth inner wall body 72 is further included.

If the second inner side wall 70 includes only a single-layer inner wall body, an opening of the emitter region window is relatively large, and the finally formed emitter region has a large area and small resistance.

After the first inner side wall 60 is formed, step S40 is performed, and when ion implantation is performed to form the collector region 18, ion implantation is performed on the first inner side wall 60, affecting isolation effect between the extrinsic base region and the emitter region that are subsequently formed. Therefore, after the first inner side wall 60 is removed and the second inner side wall 70 is formed again, the foregoing problem can be resolved, and the isolation effect between the extrinsic base region and the emitter region can be improved. In addition, in a process of forming the first opening 32, a part that is of the first inner wall body 64 and that is in contact with the first sacrificial film 31 is removed synchronously, that is, a cross section of the first inner wall body 64 is strip-shaped. As a result, the first inner wall body 64 cannot implement isolation in the region. A third inner wall body 71 included in the second inner wall body 70 that is formed again is L-shaped and has a wide coverage area, so that isolation effect between the extrinsic base region and the emitter region can be improved.

S80: Clean a surface of the intrinsic base region 21.

For example, the surface of the intrinsic base region 21 may be cleaned through wet etching, to remove an intrinsic oxidized layer generated after the surface of the intrinsic base region 21 is oxidized.

After the intrinsic base region 21 is formed, step S70 is further performed. As a result, an exposed surface of the intrinsic base region 21 is prone to oxidation to produce SiO2, which affects electrical contact effect between the subsequently formed emitter region and the subsequently intrinsic base region 21, leading to higher resistance in the emitter region. The surface of the intrinsic base region 21 is cleaned, so that SiO2 on the surface of the intrinsic base region 21 can be removed. This improves the electrical contact effect between the subsequently formed emitter region and the subsequently intrinsic base region 21, facilitates epitaxy growth of a single crystal material in the emitter region, and effectively reduces resistance of the emitter region.

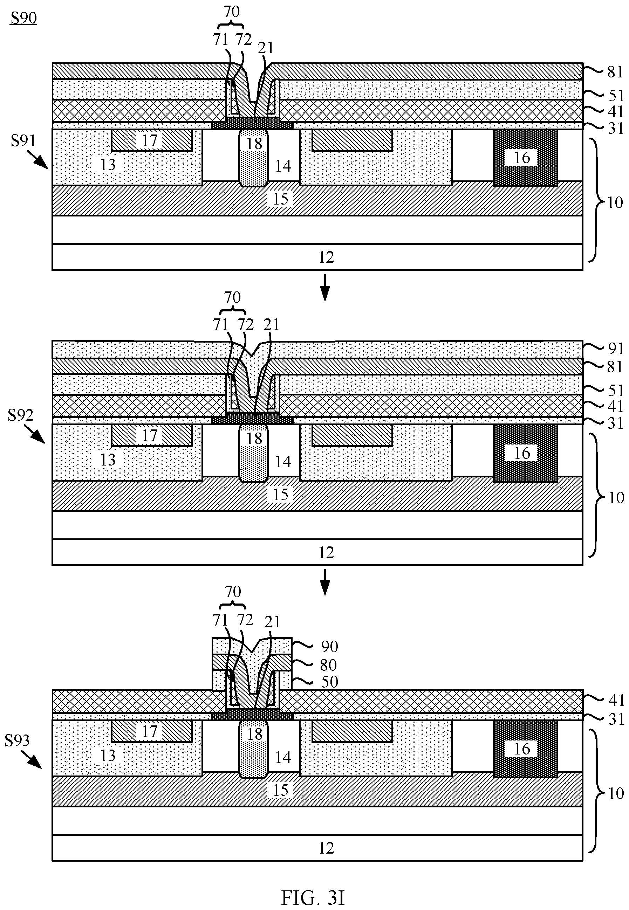

S90: Form, at the emitter region window, an emitter region film 81 that is in contact with the intrinsic base region 21, and pattern the emitter region film 81 and the auxiliary film 51, to form an emitter region 80 and an auxiliary layer 50, as shown in FIG. 3I.

A material of the emitter region 80 may be, for example, doped epitaxial monocrystalline silicon or polycrystalline silicon, or in-situ doping may be performed on the emitter region 80, to enhance doping concentration.

In some embodiments, the semiconductor structure does not include a cap layer, or a cap layer is not formed synchronously with the emitter region 80. In this case, the forming the emitter region 80 includes:
forming the emitter region film 81, where the emitter region film 81 covers the auxiliary film 51 and the second inner side wall 70. Then, the emitter region film 81 is patterned, to form the emitter region 80.

When the emitter region film 81 is patterned, the auxiliary film 51 is patterned synchronously (a part that is of the auxiliary film 51 and that is not covered by the emitter region 80 is removed). In other words, the emitter region 80 and the auxiliary layer 50 are formed synchronously.

For example, the auxiliary film 51 may be patterned through photolithography and dry etching processes, to form the auxiliary layer 50.

In some other embodiments, as shown in FIG. 3I, the emitter region 80 and a cap layer 90 are formed synchronously. In this case, the forming the emitter region 80 includes the following steps.

S91: Form the emitter region film 81 on the auxiliary film 51.

For example, the emitter region film 81 may be formed through the epitaxy growth process. A material of the emitter region film 81 may be, for example, doped epitaxial monocrystalline silicon or polycrystalline silicon.

S92: Form a cap film 91 on the emitter region film 81.

A material of the cap film 91 may be a dielectric material, and a material of the cap film 91 is, for example, silicide. For example, the material of the cap film 91 is silicon oxide, silicon nitride, silicon oxynitride, or oxygen-rich silicon dioxide.

For example, the cap film 91 may be formed through the CVD process, and the cap film 91 covers the emitter region film 81.

S93: Pattern a film (for example, the auxiliary film 51, the emitter region film 81, and the cap film 91) on a side that is of the second sacrificial film 41 and that is away from the substrate 10, to form the auxiliary layer 50, the emitter region 80, and the cap layer 90.

For example, the auxiliary film 51, the emitter region film 81, and the cap film 91 are patterned through the photolithography and etching processes, to expose the second sacrificial film 41.

The patterning of the auxiliary film 51, the emitter region film 81, and the cap film 91 may be completed in a plurality of processes, or may be completed in a same process. Specific patterns of structures retained after the auxiliary film 51, the emitter region film 81, and the cap film 91 are patterned are not limited, provided that the patterns are appropriately set based on a requirement.

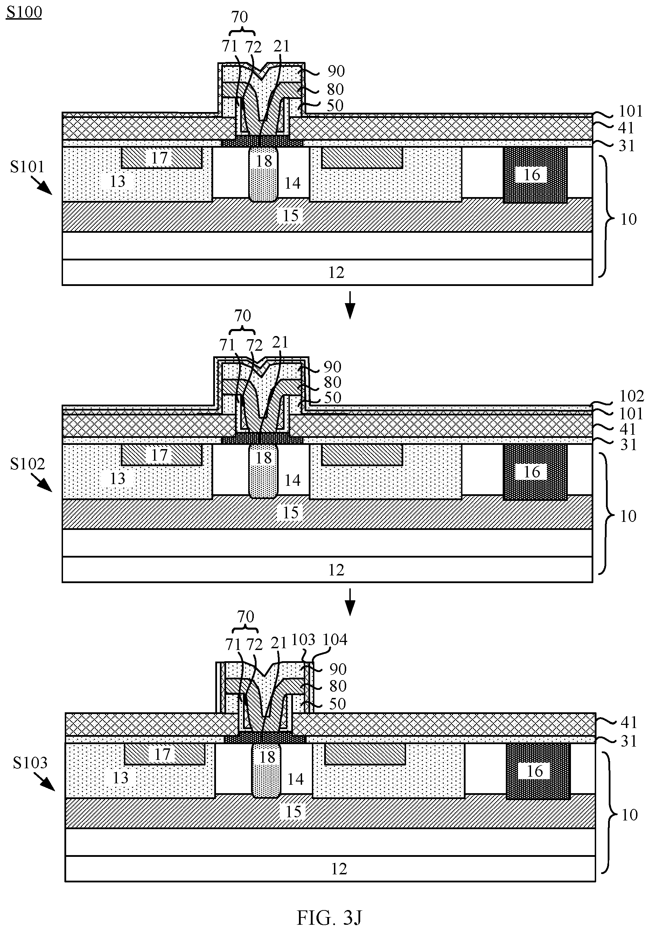

S100: Form a first outer wall body 103 and a second outer wall body 104, as shown in FIG. 3J.

The first outer wall body 103 is disposed between the second outer wall body 104 and the emitter region 80. The first outer wall body 103 and the second outer wall body 104 wrap at least a side surface of the emitter region 80.

In some embodiments, as shown in FIG. 3J, the first outer wall body 103 and the second outer wall body 104 wrap side surfaces of the auxiliary layer 50, the emitter region 80, and the cap layer 90.

As shown in FIG. 3J, in some embodiments, a method for forming the first outer wall body 103 and the second outer wall body 104 includes the following steps.

S 101: Form a third dielectric film 101 on the substrate 10 on which the cap layer 90 is formed.

A manner of forming the third dielectric film 101 may be, for example, forming the third dielectric film 101 through the CVD process.

A material of the third dielectric film 101 may be a dielectric material, and a material of the third dielectric film 101 is, for example, silicide. For example, the material of the third dielectric film 101 is SiO2, Si3N4, silicon oxynitride, or oxygen-rich silicon dioxide.

In some embodiments, the material of the third dielectric film 101 is different from a material of the first sacrificial film 31. For example, the material of the third dielectric film 101 is Si3N4, and the material of the first sacrificial film 31 is SiO2.

In this way, when the first sacrificial film 31 is subsequently removed, the first outer side wall 103 formed by the third dielectric film 101 is not removed, to ensure that the outer side wall protects the emitter region 21.

S102: Form a fourth dielectric film 102 on the third dielectric film 101.

A manner of forming the fourth dielectric film 102 may be, for example, forming the fourth dielectric film 102 through the CVD process.

A material of the fourth dielectric film 102 may be a dielectric material, and the material of the fourth dielectric film 102 is, for example, silicide. For example, the material of the fourth dielectric film 102 is SiO2, Si3N4, silicon oxynitride, or oxygen-rich silicon dioxide.

In some embodiments, the material of the fourth dielectric film 102 is different from the material of the second sacrificial film 41. For example, the material of the fourth dielectric film 102 is SiO2, and the material of the second sacrificial film 41 is Si3N4.

In this way, when the second sacrificial film 41 is subsequently removed, the second outer side wall 104 formed by the fourth dielectric film 102 is not removed, to protect the emitter region 21.

S 103: Pattern the third dielectric film 101 and the fourth dielectric film 102, to form the first outer wall body 103 and the second outer wall body 104.

For example, the third dielectric film 101 and the fourth dielectric film 102 may be patterned through the etching process, to form the first outer wall body 103 and the second outer wall body 104.

A process of patterning the third dielectric film 101 and the fourth dielectric film 102 may be completed in a same process, or may be separately completed in a plurality of processes.

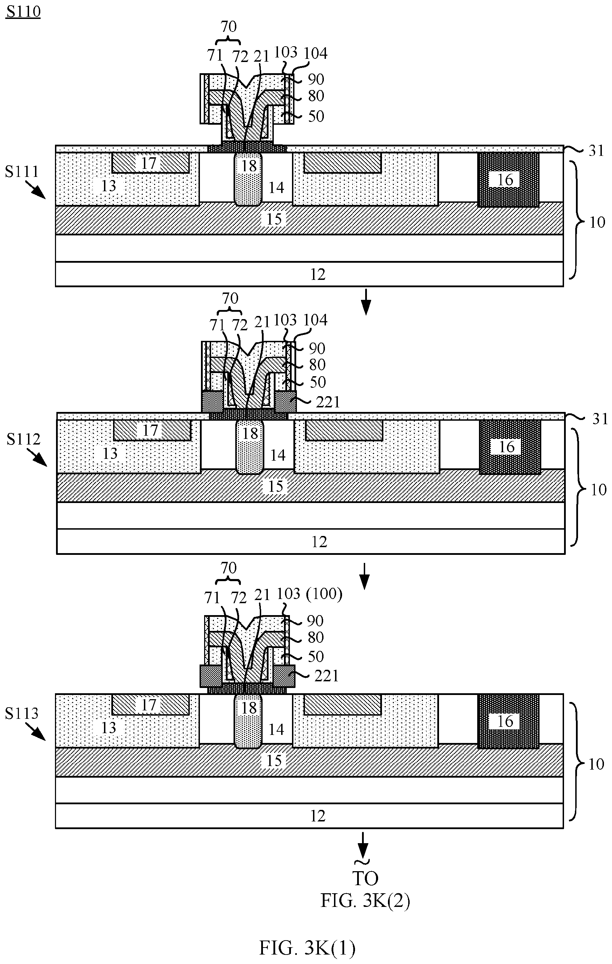

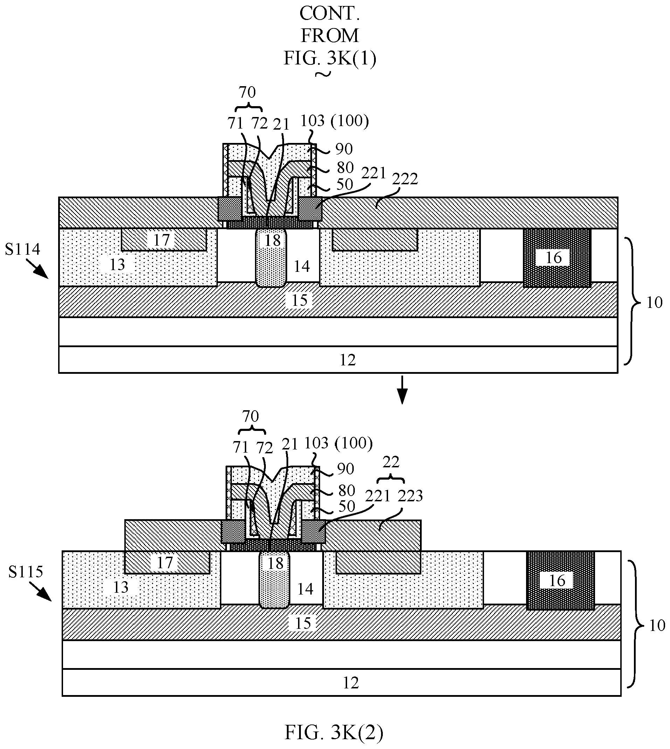

S110: Remove the first sacrificial film 31 and the second sacrificial film 41 to form an extrinsic base region 22 at corresponding positions, as shown in FIG. 3K(1).

In some embodiments, as shown in FIG. 3K(1) and FIG. 3K(2), a method for forming the extrinsic base region 22 includes the following steps.

S111: Remove the second sacrificial film 41.

For example, the second sacrificial film 41 may be removed through the etching process. Two ends of the intrinsic base region 21 are exposed to function as a seed crystal for forming a baselink region 221.

S112: Form the baselink region 221 under the auxiliary layer 50.

For example, the baselink region 221 may be formed through the selective epitaxy growth process.

A size of the baselink region 221 is not limited in this embodiment of this application, provided that the baselink region 221 is in contact with the intrinsic base region 21. A structure of the baselink region 221 shown in FIG. 3K(1) and FIG. 3K(2) is merely an example, and is not limited.

A material of the baselink region 221 may include, for example, heavily doped monocrystalline silicon, and may further include a small quantity of polycrystalline silicon.

S 113: Remove the first sacrificial film 31.

For example, the first sacrificial film 31 may be removed through the etching process. The surface of the substrate 10 is exposed, and the auxiliary extrinsic base region 17 is exposed.

If materials of the second outer wall body 104 and the first sacrificial film 31 are the same, the second outer wall body 104 is removed when the first sacrificial film 31 is removed. The reserved first outer wall body 103 functions as an outer side wall 100 of the semiconductor structure, and the outer side wall 100 is configured to protect the emitter region 80.

S114: Form an extrinsic base region film 222 at a corresponding position of the first sacrificial film 31.

For example, the extrinsic base region film 222 may be formed at the corresponding position of the first sacrificial film 31 through the selective epitaxy growth process. In other words, the extrinsic base region film 222 is formed on the surface of the substrate 10, and the extrinsic base region film 222 is in direct contact with the auxiliary extrinsic base region 17.

A material of the extrinsic base region film 222 may be, for example, polycrystalline silicon or polycrystalline silicon silicide. In some embodiments, in-situ doping may be further performed on the extrinsic base region film 222.

The formed extrinsic base region film 222 may be in contact with the intrinsic base region 21, or may not be in contact with the intrinsic base region 21. In other words, an effective extrinsic base region 223 formed by using the extrinsic base region film 222 may be in contact with the intrinsic base region 21, or may not be in contact with the intrinsic base region 21.

S115: Pattern the extrinsic base region film 222, to form the effective extrinsic base region 223.

For example, the extrinsic base region film 222 may be patterned through the photolithography and etching processes. In some other embodiments, a method for forming the extrinsic base region 22 includes: The auxiliary extrinsic base region 17 further functions as a seed layer of the extrinsic base region film 222, and directly epitaxially grows the extrinsic base region 22 on the auxiliary extrinsic base region 17. The sinker region 16 is covered with a dielectric protection layer, to ensure that the extrinsic base region 22 epitaxially grows only on the auxiliary extrinsic base region 17, and a structure in S115 is directly obtained. This saves patterning steps, such as photolithography and etching, performed on the extrinsic base region.

Based on this, as shown in FIG. 3K(2), the extrinsic base region 22 formed by using the foregoing method includes the effective extrinsic base region 223 and the baselink region 221. The effective extrinsic base region 223 is in contact with the baselink region 221, and the baselink region 221 is in contact with the intrinsic base region 21, so that the extrinsic base region 22 is in contact with the intrinsic base region 21. The material of the baselink region 221 is quasi-single-crystalline silicon, and an activation rate of a doping ion of the baselink region 221 is greater than that of the effective extrinsic base region 223 (a material is polycrystalline silicon). Therefore, the contact between the effective extrinsic base region 223 and the intrinsic base region 21 is implemented through the baselink region 221, so that contact resistance between the extrinsic base region 22 and the intrinsic base region 21 can be reduced.

In addition, if the auxiliary extrinsic base region 17 is further disposed in the substrate 10, as shown in FIG. 3K(1) and FIG. 3K(2), the effective extrinsic base region 223 is in contact with the auxiliary extrinsic base region 17 on the surface of the substrate 10. The effective extrinsic base region 223 is in contact with the auxiliary extrinsic base region 17, which is equivalent to increasing a thickness of the effective extrinsic base region 223. This may raise the extrinsic base region 22, to reduce resistance of the extrinsic base region 22.

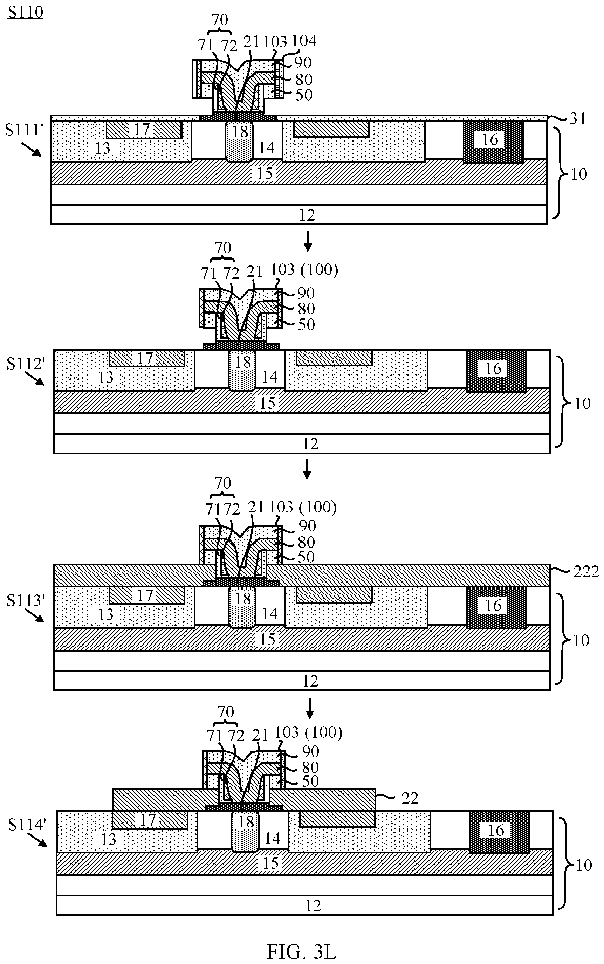

In some other embodiments, as shown in FIG. 3L, a method for forming the extrinsic base region 22 includes the following steps.

S111': Remove the second sacrificial film 41.

S112': Remove the first sacrificial film 31.

Certainly, a process of removing the second sacrificial film 41 and a process of removing the first sacrificial film 31 may be completed in a same process, or may be completed in different processes.

S113': Form the extrinsic base region film 222 at corresponding positions of the first sacrificial film 31 and the second sacrificial film 41.

S114': Pattern the extrinsic base region film 222, to form the extrinsic base region 22.

As shown in FIG. 3L, the formed extrinsic base region 22 is directly linked to the intrinsic base region 21, and the extrinsic base region 22 is in contact with the auxiliary extrinsic base region 17 on the surface of the substrate 10, so that the extrinsic base region 22 may be raised, to reduce the resistance of the extrinsic base region 22.

S120: Perform heat treatment on the semiconductor structure.

Heat treatment (for example, annealing) is performed on a structure obtained in FIG. 3K(2) or FIG. 3L, and doping distribution in the emitter region 80, the intrinsic base region 21, the extrinsic base region 22, and the collector region 18 is adjusted, to activate doping ions.

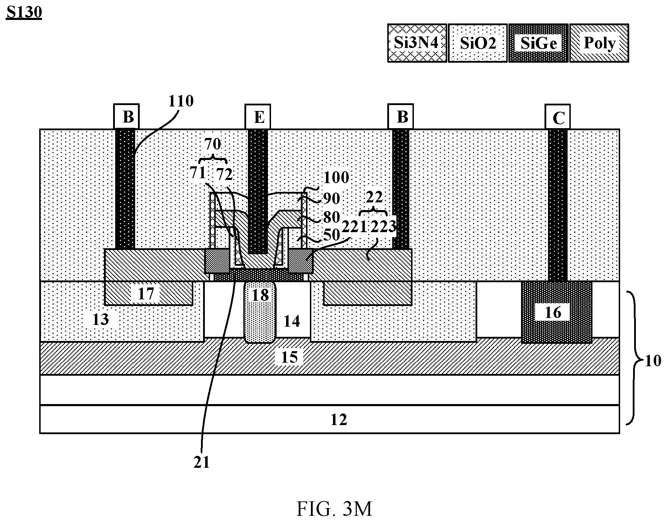

S130: Extract an emitter electrode (emitter electrode, E) from the emitter region 80, extract a base electrode (base electrode, B) from the extrinsic base region 22, and extract a collector electrode (collector electrode, C) from the collector region 18, as shown in FIG. 3M.

The emitter electrode E is in contact with the emitter region 80 through a connection hole (contact) 110 provided in a surface of the emitter region 80. The base electrode B is in contact with the extrinsic base region 22 through a connection hole 110 in a surface of the extrinsic base region 22. The sinker region 16 is in contact with the collector region 18 through the buried collector region 15, and the collector electrode C is in contact with the sinker region 16 through a connection hole 110 provided in a surface of the sinker region 16, so that the collector electrode C is in contact with the collector region 18.

Certainly, it may be understood that, if surfaces of the emitter region 80, the extrinsic base region, and the sinker region 16 are covered with a dielectric layer, the connection hole 100 passes through the dielectric layer and is in contact with the emitter region 80, the extrinsic base region, and the sinker region 16.

It should be noted that the preparation method for the semiconductor structure provided in this embodiment of this application is not limited to the foregoing steps, and another step may be added or some of the foregoing steps may be removed as required. In addition, an order of the steps in the foregoing preparation method is merely an example, and may be adjusted based on a requirement.

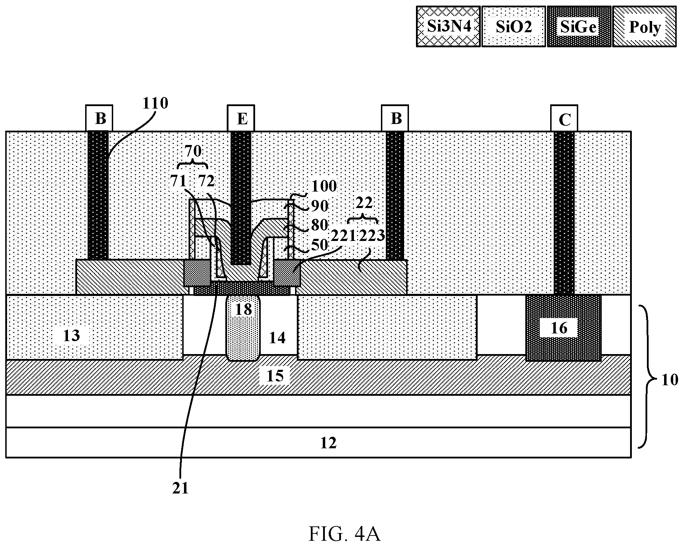

The semiconductor structure obtained by using the foregoing steps S10 to S130 is an HBT device. As shown in FIG. 4A, the semiconductor structure includes:
the substrate 10, including the shallow trench isolation region 13 and the active region 14. The active region 14 includes the buried collector region 15, the sinker region 16, and the collector region 18.

The collector region 18 is buried in the substrate 10, and a surface of the collector region 18 is flush with the surface of the substrate 10. The collector region 18 is located in the active region 14 under the intrinsic base region 21. The shallow trench isolation region 13 is disposed at a periphery of the active region 14 under the intrinsic base region 21. The sinker region 16 is located on a side that is of the shallow trench isolation region 13 and that is away from the collector region 18. The sinker region 16 and the shallow trench isolation region 13 are located on the buried collector region 15. Both the sinker region 16 and the collector region 18 are in contact with the buried collector region 15.

In some embodiments, if steps S18, S19-1, and S19-2 are performed in a preparation process, as shown in FIG. 3M, the substrate 10 further includes the auxiliary extrinsic base region 17. The auxiliary extrinsic base region 17 is disposed in the shallow trench isolation region 13, and the surface of the auxiliary extrinsic base region 17 functions as a part of the surface of the substrate 10.

The intrinsic base region 21 is disposed on the surface of the substrate 10, is in contact with the collector region 18 on the surface of the substrate 10, and forms a collector junction (C-B). The material of the intrinsic base region 21 may be, for example, SiGe or SiGe:C.

The extrinsic base region 22 is disposed on the surface of the substrate 10, and is in contact with the auxiliary extrinsic base region 17 on the surface of the substrate 10. The extrinsic base region 22 is located at a periphery of the intrinsic base region 21, and is in contact with the intrinsic base region 21. A material of the extrinsic base region 22 may be, for example, polycrystalline silicon.

Structures of the prepared extrinsic base region 22 are different by using the foregoing different methods. In some embodiments, in the process of preparing the semiconductor structure, step S111 to step S115 are performed, to form the extrinsic base region 22.

As shown in FIG. 3M and FIG. 4A, the extrinsic base region 22 includes the baselink region 221 and the effective extrinsic base region 223, and the baselink region 221 is in contact with both the intrinsic base region 21 and the effective extrinsic base region 223.

In some embodiments, as shown in FIG. 4A, the baselink region 221 is linked to the intrinsic base region 21, and the baselink region 221 is linked to the effective extrinsic base region 223.

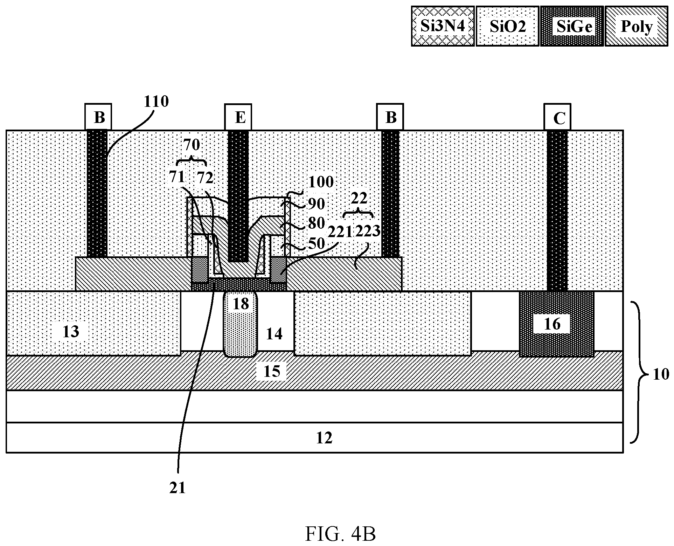

In some other embodiments, as shown in FIG. 4B, the baselink region 221 is disposed on the intrinsic base region 21, and the baselink region 221 is spliced with the effective extrinsic base region 223.

Based on different structures of the baselink region 221, the baselink region 221 is in contact with both the intrinsic base region 21 and the effective extrinsic base region 223 in different manners. The foregoing is merely an example, and is not limited.

In addition, as shown in FIG. 4A, the effective extrinsic base region 223 may not be in contact with the intrinsic base region 21. As shown in FIG. 4B, the effective extrinsic base region 223 may alternatively be in contact with the intrinsic base region 21.

In some other embodiments, in the process of preparing the semiconductor structure, step S111' to step S114' are performed, to form the extrinsic base region 22.

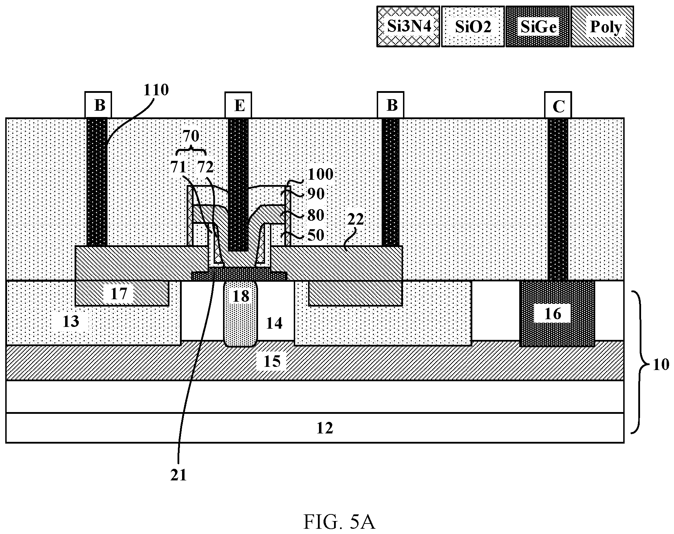

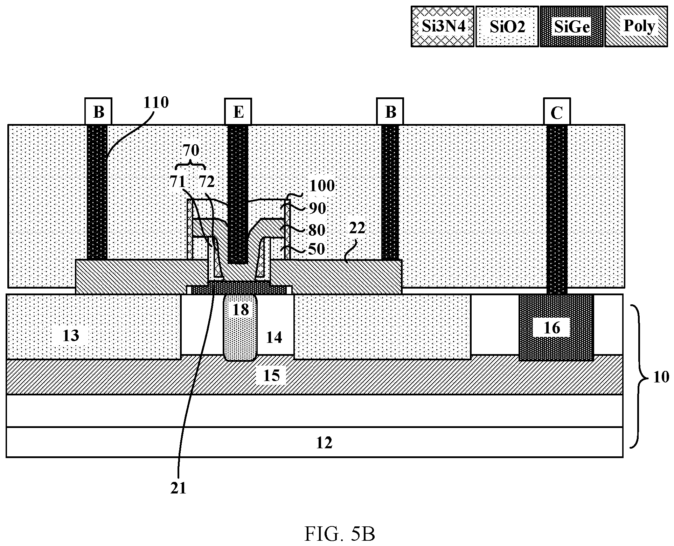

As shown in FIG. 5A and FIG. 5B, the extrinsic base region 22 does not include the baselink region, and materials of all parts of the extrinsic base region 22 are the same.

The auxiliary layer 50 has an opening, and the auxiliary layer 50 is disposed on the extrinsic base region 22. The opening in the auxiliary layer 50 may be understood as the third opening 52 in the auxiliary film 51 in the foregoing preparation process. A material of the auxiliary layer 50 may be, for example, SiO2.

The emitter region 80 is disposed on the auxiliary layer 50, and is in contact with the intrinsic base region 21 through the opening, to form an emitter junction (E-B). The material of the emitter region 80 may be, for example, doped epitaxial monocrystalline silicon or polycrystalline silicon.

An inner side wall is disposed between the extrinsic base region 22 and the emitter region 80, may further extend between the auxiliary layer 50 and the emitter region 80, and is configured to isolate the extrinsic base region 22 from the emitter region 80.

In some embodiments, step S70 is performed in the preparation process of the semiconductor structure. In this case, the inner side wall in the semiconductor structure may be the second inner side wall 70.

Certainly, the second inner side wall 70 may include the third inner wall body 71 and the fourth inner wall body 72. The second inner wall body 70 may alternatively include only the third inner wall body 71. In either case, the inner side wall includes an L-shaped part (the third inner wall body 71). A material of the third inner wall body 71 may be, for example, SiO2, and a material of the fourth inner wall body 72 may be, for example, Si3N4.

In some other embodiments, step S70 is not performed in the preparation process of the semiconductor structure. In this case, the inner side wall in the semiconductor structure may be the first inner side wall 60.

Certainly, the first inner side wall 60 may include the first inner wall body 64 and the second inner wall body 63. The first inner side wall 60 may alternatively include only the first inner wall body 64. A material of the first inner wall body 64 may be, for example, SiO2, and a material of the second inner wall body 63 may be, for example, Si3N4. The cap layer 90 covers a surface that is of the emitter region 80 and that is away from the substrate 10, and is configured to protect the emitter region 80. A material of the cap layer 90 may be, for example, SiO2.

The outer side wall 100 wraps a side surface of the emitter region 80, and is configured to protect the emitter region 80. The outer side wall 100 may be the first outer wall body 103 in the foregoing preparation process. A material of the outer side wall 100 may be, for example, Si3N4.

The collector electrode C is in contact with the collector region 18 through a connection hole 100 that is in contact with the sinker region 16 through the sinker region 16 and the buried collector region 15. The connection hole 100 may be directly provided in the surface of the sinker region 16, and a metal silicide layer may further be disposed between the connection hole 100 and the sinker region 16, to implement contact between the connection hole 100 and the sinker region 16.

The emitter electrode E is in contact with the emitter region 80 through a connection hole 100 that passes through the cap layer 90 and is in contact with the emitter region 80. The connection hole 100 may be directly provided in the surface of the emitter region 80, and a metal silicide layer may further be disposed between the connection hole 100 and the emitter region 80, to implement contact between the connection hole 100 and the emitter region 80.

The base electrode B is in contact with the extrinsic base region 22 through a connection hole 100 that is in contact with the extrinsic base region 22. The connection hole 100 may be directly provided in the surface of the extrinsic base region 22, and a metal silicide layer may further be disposed between the connection hole 100 and the extrinsic base region 22, to implement contact between the connection hole 100 and the extrinsic base region 22.

It should be understood that, if the emitter region 80, the extrinsic base region 22, and the sinker region 16 are covered with a dielectric layer, the connection hole 100 inevitably passes through the dielectric layer.

An NPN HBT device is used as an example. The emitter electrode E is configured to emit electrons. The base electrode B is configured to control the electrons (so that a current flowing to the collector electrode C is controlled by an input signal of the base electrode B). The collector electrode C is configured to collect the electrons.

It should be noted that a SiGe HBT transistor in the foregoing semiconductor structure may be an NPN transistor (the intrinsic base region 21 is a P region, that is, the semiconductor is a P-type semiconductor; both the emitter region 80 and the collector region 18 are N regions, that is, the semiconductor is an N-type semiconductor), or a PNP transistor (the intrinsic base region 21 is an N region, that is, the semiconductor is an N-type semiconductor; both the emitter region 80 and the collector region 18 are P regions, that is, the semiconductor is a P-type semiconductor).

In addition, structures, positions, and quantities of the emitter electrode E, the base electrode B, and the collector electrode C that are shown in the schematic diagrams of embodiments of this application are merely examples. There may be only one emitter electrode E, one base electrode B, and one collector electrode C. Alternatively, there may be one base electrode B and one collector electrode C on a left side of the emitter electrode E, and one base electrode B and one collector electrode C on a right side of the emitter electrode E.

A material of the film layer in FIG. 3M is merely an example, and is not limited.

The NPN HBT device is used as an example to describe a working principle of the SiGe HBT device provided in this embodiment of this application. A power supply is applied to the emitter junction, the emitter junction is positively biased, and majority carriers (free electrons) in the emitter region 80 continuously cross the emitter junction and enter the intrinsic base region 21, to form an emitter current. After entering the intrinsic base region 21, the electrons first accumulate near the emitter junction, and gradually form an electron concentration difference. Under effect of the concentration difference, an electron flow is driven to diffuse toward the collector junction in the intrinsic base region 21, and is pulled into the collector region 18 by an electric field of the collector junction, to form a collector current. A small part of electrons (because the intrinsic base region 21 is extremely thin) are combined with holes in the intrinsic base region 21, and a ratio of a diffused electron flow to a combined electron flow determines an amplification capability of a triode. Due to a large reverse voltage applied to the collector junction, an electric field force generated by this reverse voltage prevents electrons in the collector region 18 from diffusing into the intrinsic base region 21, and pulls electrons that are diffused near the collector junction into the collector region 18, to form a main collector current. In addition, minority carriers (holes) in the collector region 18 also perform drift motion, and flow toward the intrinsic base region 21, to form a reverse saturation current.

According to the preparation method for the semiconductor structure provided in this embodiment of this application, the first sacrificial film 31, the second sacrificial film 41, and the auxiliary film 51 function as self-aligned structures, and may be used to implement self-alignment of the collector junction (C-B) and self-alignment of the emitter junction (E-B). In this case, the collector junction and the emitter junction that are obtained through preparation are axisymmetric structures, and no deviations occur in photolithography and etching processes, preventing asymmetry in both the collector junction and the emitter junction. The emitter junction is asymmetric. As a result, parasitic collector junction capacitance and base region resistance on two sides of the emitter junction are different, a current cannot be evenly distributed on the two sides, and total resistance and capacitance cannot be minimized. The two sides are symmetric, so that the base region resistance and the collector junction capacitance can be minimized, and a maximum oscillation frequency of the device is increased. The collector junction is asymmetric. As a result, parasitic collector resistance on two sides of the collector junction is different, and an objective of reducing the collector resistance cannot be implemented either. In addition, in this embodiment of this application, preparation of each film layer may be implemented by using a conventional technology. The collector region 18 is also formed by defining a position by using the self-aligned structure and then performing ion implantation on the substrate 10.

In addition, both the intrinsic base region 21 and the extrinsic base region 22 are disposed on the surface of the substrate 10, and the collector region 18 is disposed inside the substrate 10. There is no raised epitaxial collector region. Therefore, both the intrinsic base region 21 and the extrinsic base region 22 are directly formed on the surface of the known substrate 10, and whether the intrinsic base region 21 is in contact with the extrinsic base region 22 is directly controlled by preparation processes of the intrinsic base region and the extrinsic base region. Compared with the intrinsic base region disposed on the epitaxial collector region that is disposed on the surface of the substrate 10, the intrinsic base region 21 is directly disposed on the surface of the substrate 10 in this embodiment of this application. In this case, contact between the intrinsic base region 21 and the extrinsic base region 22 is not affected due to a parameter like a thickness of the raised epitaxial collector region. This can improve a contact yield between the intrinsic base region 21 and the extrinsic base region 22, and further improve a yield of the semiconductor structure. In addition, impact of the thickness of the collector region 18 on contact effect between the intrinsic base region 21 and the extrinsic base region 22 does not need to be considered. Therefore, this can reduce a requirement for process accuracy of manufacturing the collector region 18, and reduce a process difficulty. In addition, the collector region 18 is obtained through doping, and an epitaxy growth process (for preparing the collector region 18) is not needed. This saves processing costs.

In addition, an auxiliary extrinsic base region 17 is disposed in the substrate 10, and the auxiliary extrinsic base region 17 functions as a seed layer for epitaxy growth of the extrinsic base region 22. After the extrinsic base region 22 is grown, the auxiliary extrinsic base region 17 is in contact with the extrinsic base region 22, to implement thickening of the extrinsic base region 22. This can implement an objective of reducing resistance of the extrinsic base region. In some embodiments, the semiconductor structure further includes a complementary metal-oxide-semiconductor field-effect transistor (complementary metal oxide semiconductor field-effect transistor, CMOSFET).

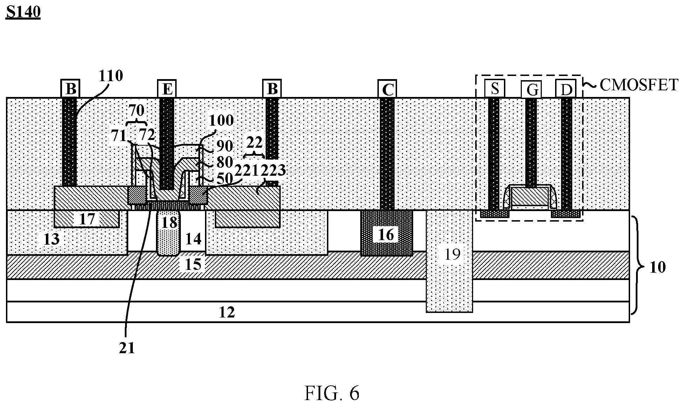

As shown in FIG. 6, the preparation method for the semiconductor structure further includes: S140, that is, forming the CMOSFET on the base 11.

The step of forming the CMOSFET on the base 11 may be performed before step S10, or may be performed after step S130.

As shown in FIG. 6, a SiGe HBT structure and the CMOSFET structure are isolated from each other through a deep trench isolation region 19 in the substrate 10.

In addition, the CMOSFET structure is not limited in this embodiment of this application, and the CMOSFET in FIG. 6 is merely an example. The CMOSFET may be an NMOS transistor or a PMOS transistor.

In this way, the semiconductor structure obtained through preparation by using the preparation method for the semiconductor structure is a CMOS+SiGe HBT device, and the CMOS and the SiGe HBT may be integrated on a same chip.

After the semiconductor structure obtained through preparation by using the preparation method provided in this embodiment of this application is applied to a transistor circuit, the transistor circuit may be directly packaged by using a package body, to form a packaged component (for example, a chip), or may be packaged together with another chip, to form a packaged component. This is not limited in this embodiment of this application.

Based on this, in some embodiments, the transistor circuit including any one of the foregoing semiconductor structures may be used in a radio frequency circuit.

The radio frequency circuit may be used in fields, for example, a microwave system, an optoelectronic system, radar, image, and sensing. The radio frequency circuit may be, for example, a power amplifier (power amplifier, PA), a variable gain amplifier (variable gain amplifier, VGA), a low noise amplifier (low noise amplifier, LNA), a trans-impedance amplifier (trans-impedance amplifier, TIA), a driver (driver), a frequency mixer, or a clock data recovery (clock data recovery, CDR) circuit.

Certainly, an application scope of the foregoing semiconductor structure is not limited in this embodiment of this application. For example, the semiconductor structure may be applied to any communication apparatus. The communication apparatus may be a network device, or may be a terminal.

The foregoing descriptions are only specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor structure, comprising:
a substrate, comprising a collector region buried in the substrate;
an intrinsic base region, disposed on a surface of the substrate, and in contact with the collector region on the surface of the substrate;
an extrinsic base region, disposed on the surface of the substrate, located at a periphery of the intrinsic base region, and in contact with the intrinsic base region;
an auxiliary layer having an opening, wherein the auxiliary layer is disposed on the extrinsic base region;
an emitter region, disposed on the auxiliary layer, and in contact with the intrinsic base region through the opening; and
an inner side wall, disposed between the extrinsic base region and the emitter region.

2. The semiconductor structure according to claim 1, wherein the substrate further comprises a shallow trench isolation region, the shallow trench isolation region is disposed at a periphery of an active region under the intrinsic base region, and the collector region is located in the active region.

3. The semiconductor structure according to claim 1, wherein the substrate further comprises an auxiliary extrinsic base region, the auxiliary extrinsic base region is disposed in the shallow trench isolation region, and the extrinsic base region is in contact with the auxiliary extrinsic base region on the surface of the substrate.

4. The semiconductor structure according to any one of claims 1 to 3, wherein the extrinsic base region comprises a baselink region and an effective extrinsic base region, and the baselink region is in contact with both the intrinsic base region and the effective extrinsic base region.

5. The semiconductor structure according to claim 4, wherein the baselink region is linked to the intrinsic base region and/or the effective extrinsic base region.

6. The semiconductor structure according to any one of claims 1 to 5, wherein the semiconductor structure further comprises an outer side wall, wherein
the outer side wall wraps a side surface of the emitter region, and is configured to protect the emitter region.

7. The semiconductor structure according to any one of claims 1 to 6, wherein the semiconductor structure further comprises a cap layer, and the cap layer covers a surface that is of the emitter region and that is away from the substrate, and is configured to protect the emitter region.

8. The semiconductor structure according to any one of claims 1 to 7, wherein the inner side wall comprises an inner wall body, the inner wall body is disposed on a surface that is of the extrinsic base region and that faces the emitter region, and the inner wall body is L-shaped.

9. The semiconductor structure according to any one of claims 1 to 8, wherein the semiconductor structure further comprises an emitter electrode, a base electrode, and a collector electrode that are disposed on the substrate; and
the emitter electrode is in contact with the emitter region, the base electrode is in contact with the extrinsic base region, and the collector electrode is in contact with the collector region.

10. The semiconductor structure according to claim 9, wherein the substrate further comprises a sinker region and a buried collector region, the sinker region and the shallow trench isolation region are located on the buried collector region, the sinker region is located on a side that is of the shallow trench isolation region and that is away from the collector region, and both the sinker region and the collector region are in contact with the buried collector region;
the collector electrode is in contact with the collector region through a connection hole that is in contact with the sinker region;
the emitter electrode is in contact with the emitter region through a connection hole that passes through the cap layer and is in contact with the emitter region; and
the base electrode is in contact with the extrinsic base region through a connection hole that is in contact with the extrinsic base region.

11. The semiconductor structure according to any one of claims 1 to 10, wherein the semiconductor structure further comprises a complementary metal-oxide-semiconductor field-effect transistor, and the complementary metal-oxide-semiconductor field-effect transistor is disposed on the substrate.

12. A radio frequency circuit, comprising a transistor circuit that comprises the semiconductor structure according to any one of claims 1 to 11.

13. A preparation method for a semiconductor structure, comprising:
forming a base, wherein the base comprises an active region and a shallow trench isolation region;
forming, on a surface of the base, a first sacrificial film, a second sacrificial film, and an auxiliary film that are sequentially stacked, forming a second opening in the second sacrificial film, and forming a third opening in the auxiliary film, wherein the second opening is in communication with the third opening to function as an emitter region window;
forming a first inner side wall, wherein the first inner side wall is disposed around a surface that is of the second sacrificial film and that faces the emitter region window;
forming a collector region, wherein the collector region is located in the active region directly below the emitter region window;
forming a first opening in the first sacrificial film, wherein the first opening is in communication with the second opening;
forming an intrinsic base region in the first opening;
forming, at the emitter region window, an emitter region film that is in contact with the intrinsic base region, and patterning the emitter region film and the auxiliary film, to form an emitter region and an auxiliary layer; and
removing the first sacrificial film and the second sacrificial film to form an extrinsic base region at corresponding positions, wherein the extrinsic base region is in contact with the intrinsic base region.

14. The preparation method for the semiconductor structure according to claim 13, wherein the forming a base further comprises:
forming an auxiliary extrinsic base region in the shallow trench isolation region, wherein the extrinsic base region is in contact with the auxiliary extrinsic base region on the surface of the base.

15. The preparation method for the semiconductor structure according to claim 13 or 14, wherein the removing the first sacrificial film and the second sacrificial film to form an extrinsic base region at corresponding positions comprises:
removing the second sacrificial film to form a baselink region under the auxiliary layer, wherein the baselink region is in contact with the intrinsic base region; and
removing the first sacrificial film to form an effective extrinsic base region at a corresponding position, wherein the effective extrinsic base region is in contact with the baselink region.

16. The preparation method for the semiconductor structure according to any one of claims 13 to 15, wherein a contour of the second opening is within a contour of the first opening.

17. The preparation method for the semiconductor structure according to any one of claims 13 to 16, wherein before the forming, at the emitter region window, an emitter region that is in contact with the intrinsic base region, the preparation method further comprises:
removing the first inner side wall to form a second inner side wall.

18. The preparation method for the semiconductor structure according to claim 17, wherein after the forming a second inner side wall, the preparation method further comprises: cleaning a surface of the intrinsic base region.

19. The preparation method according to any one of claims 13 to 18, wherein the preparation method further comprises:
forming a complementary metal-oxide-semiconductor field-effect transistor on the base.
